Europäisches Patentamt

(19) European Patent Office

Office européen des brevets

(11) Numéro de publication: **0 010 610**
**B1**

(12) **FASCICULE DE BREVET EUROPEEN**

(45) Date de publication du fascicule du brevet: **13.04.83**

(21) Numéro de dépôt: **79103618.9**

(22) Date de dépôt: **24.09.79**

(51) Int. Cl.³: **B 23 K 26/00,**
R 23 K 17/00
**B 23 K 15/00, H 01 L 21/60**

(54) Procédé pour lier des fils métalliques à des conducteurs de microcircuits.

(30) Priorité: **31.10.78 US 956158**

(43) Date de publication de la demande:
**14.05.80 Bulletin 80/10**

(45) Mention de la délivrance du brevet:
**13.04.83 Bulletin 83/15**

(84) Etats contractants désignés:
**DE FR GB**

(56) Documents cités:
SOLID STATE TECHNOLOGY, vol. 18, no. 4,
avril 1975,
Washington US
Article enonyme: "Short laser pulses to make
connections through oxide on integrated circuit
chips" page 37

(73) Titulaire: **International Business Machines**
**Corporation**
**Armonk, N.Y. 10504 (US)**

(72) Inventeur: **Tynan, Eugène, E.**
**Bullet Hole Road**
**Mahopac Falls 10541 New York (US)**
Inventeur: **Chaudhari, Praveen**
**416 Long Hill Road**
**Briarcliff Manor 12590 New York (US)**
Inventeur: **Kiessling, John B.**
**43 Edgehill Drive**
**Wappingers Falls 12590 New York (US)**
Inventeur: **Perlman, David, J.**
**Neville Road**
**Wappingers Falls 12590 New York (US)**
Inventeur: **Von Gutfeld, Robert, J.**
**600 West 115 Street**
**10025 New York (US)**

(74) Mandataire: **Gallois, Gérard**
**COMPAGNIE IBM FRANCE Département de**
**Propriété Industrielle**
**F-06610 La Gaude (FR)**

Courier Press, Leamington Spa, England.

## Procédé pour lier des fils métalliques à des conducteurs de microcircuits

Domaine technique

La présente invention concerne un procédé permettant de lier des fils à des conducteurs de dispositifs semi-conducteurs ou autres dispositifs électroniques au moyen d'un faisceau focalisé présentant une énergie élevée.

Etat de la technique antérieure

Le brevet des E.U.A. N° 3 485 996 décrit un procédé dans lequel un conducteur métallique, fixé à la partie inférieure d'un film transparent (décalque) en polyimide, qui le maintient dans une certaine mesure et qui recouvre les conducteurs d'un bloc, est soudé à ces derniers en utilisant le faisceau d'un laser à rubis qui est focalisé sur le conducteur métallique au travers du film transparent. Ce procédé ne fait appel à l'emploi d'aucune isolation.

L'article de Kuhn et al. intitulé "Experimental Study of Laser Formed Connectors for LSI Wafer Personalization" paru dans la publication "IEEE Journal of Solid State Circuits, Vol. SC10, N° 4, p. 219—229, Juillet 1975, décrit la façon dont les impulsions, d'une durée de 2 à 6 ns, d'un laser constitué par une solution de teinte rhodamine 6G permettent de souder une couché supérieure d'aluminium d'une épaisseur de 1 micron déposée sur un film de $SiO_2$ d'une épaisseur de 2 microns qui est déposé par pulvérisation sur un film inférieur d'aluminium d'une épaisseur de 1 micron. On obtient ainsi un contact présentant une résistance de 1 ohm, cette valeur étant ramenée à 0,3 ohm après une opération de recuit.

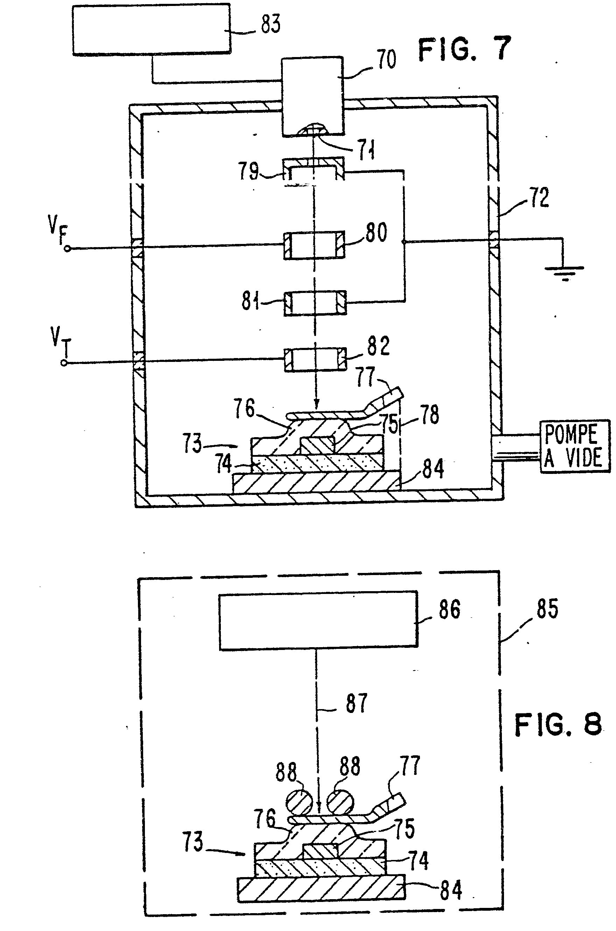

Le brevet des E.U.A. N° RE 27 772 décrit la façon dont un laser peut être employé pour réduire la résistance d'un film en perçant des trous dans celui-ci, ou au contraire pour l'augmenter en créant une connexion de shunt d'une seconde résistance en parallèle avec la première. Une impulsion laser de forte intensité et de courte durée, du type représenté sur la figure 9, permet d'engendrer un "trou ouvert" (Figures 5 et 6) qui supprime une partie du film inférieur 22 du matériau résistif. Une impulsion de plus grande durée, mais d'une intensité moindre, crée un "trou de shunt" (Figures 7 et 8), qui connecte le film résistif supérieur, en parallèle avec le film inférieur, en faisant fondre une partie du film supérieur jusqu'à travers le matériau isolant dans lequel un trou est percé pour lier les deux films l'un à l'autre.

Un article de Cook et al. paru dans la publication intitulée "IBM Technical Disclosure Bulletin", *17*, p. 242, 1974, décrit un procédé permettant de connecter une ligne métallique en aluminium qui est déposée sur un bloc sous la forme d'un film mince à une région de diffusion sous-jacente du type de conductivité P dans un substrat en Si, au moyen d'impulsions laser d'une durée de 8ns ou moins, retirant ainsi l'Al et faisant passer le Si au travers du diélectrique. Ce procédé diffère comme suit de celui de la présente invention: 1) dans la présente invention, le fil est distinct du bloc et repose simplement sur celui-ci; 2) les dimensions dont il est question dans la présente invention peuvent-être beaucoup plus faibles qu'en 1974, bien qu'aucune dimension n'ait été mentionnée dans ledit article; 3) une connexion peut être établie de façon externe par rapport à un bloc précédemment fabriqué, ce qui n'est pas le cas dans ledit article; 4) les impulsions initiales sont des impulsions de forte intensité servant à percer des trous. Les impulsions ultérieures présentent une intensité moindre et permettent d'obtenir une liaison.

L'article de Myers et al. paru dans la publication "IBM Technical Disclosure Bulletin", *20*, p. 1324, 1977, décrit une autre technique d'établissement de connexions, qui serait inefficace pour les besoins de la présente invention étant donné qu'elle se limite à établir des connexions externes avec des régions de contact externes d'un bloc lorsqu'un bloc a été omis sur une carte. Cette technique ne présente pas d'intérêt direct, sinon qu'elle fait appel à la soudure de micro-surface de fils approximativement trois fois plus gros que ceux dont il s'agit ici. Par ailleurs, ladite technique ne permet pas d'établir de nouveaux points de connexion avec un bloc, autres que ceux initialement prévus par le procédé de fabrication employé. En revanche, la présente invention permt d'établir de telles connexions internes.

Le brevet des E.U.A. n° 3 718 968 décrit un procédé de liaison d'un fil à un composant ou à un substrat au moyen d'un laser.

Le brevet des E.U.A. N° 3 402 460 décrit également un procédé de soudure d'un conducteur directement à une région de type P ou de type N au moyen d'un laser.

L'article de Magdo paru dans la publication "IBM Technical Disclosure Bulletin", *19*, p. 1217, 1976, décrit l'emploi d'un faisceau laser pour effectuer une modification technique sur les lignes métalliques d'un module auquel un bloc est fixé, ou directement sur le bloc. Cette technique exige la présence de doigts de contact sur la partie supérieure du bloc aux fins d'un nouveau câblage, et la façon dont le câblage doit être connecté à la métallisation mince n'est pas décrite.

L'article de Chang et al. paru dans la publication "IBM Technical Disclosure Bulletin", *17*, p. 1950—1951, 1974, décrit un procédé permettant d'établir une connexion métal-métal en perçant des trous au moyen d'un laser dans un bloc qui a fait l'objet d'une passivation.

D'autres brevets des E.U.A., notamment les brevets N° 2 303 319, 2 902 583 et 3 431 389, décrivent des procédés et des dispositifs faisant appel à l'emploi d'un faisceau d'électrons ou de particules chargées aux fins d'opérations de découpe, de perçage de trous et de vaporisation.

Dans l'article "Short laser pulses used to make connections through oxide on integrated circuit chips" paru dans SOLID STATE TECHNOLOGY d'avril 1975 page 37, il est décrit une méthode pour établir une connexion entre un conducteur en aluminium situé sur la surface d'une microplaquette et le silicium de la microplaquette à travers le bioxyde de silicium recouvrant la microplaquette. Une séquence de plusieurs impulsions courtes (2 à 6 nano secondes) d'un laser à pigment organique est utilisée. Les impulsions vaporisent d'abord un petit trou dans le conducteur d'aluminium puis enlèvent le bioxyde de silicium, enfin fondent le silicium qui coule à la surface pour former une connexion avec l'aluminium.

Expose de l'Invention

Il s'agit d'un procédé pour lier un fil métallique à un conducteur de microcircuit, caractérisé en ce qu'il comprend les étapes suivantes:

a) application dudit fil sur le conducteur,

b) maintien dudit fil en contact intime avec ledit conducteur,

c) application d'un faisceau d'énergie focalisé dirigé vers un point qui est au moins tangentiellement en contact avec ledit fil, et formation d'un trou dans ledit conducteur, et

d) application d'une énergie supplémentaire aux parties dudit fil qui sont adjacentes audit point afin de faire fondre let métal du fil et de faire s'écouler ce métal à l'intérieur du trou pour former un contact électrique entre le fil et le conducteur.

Il s'agit également d'un procédé pour lier un fil métallique à un conducteur de micro-circuit disposé au-dessous d'une couche isolante, caractérisé en ce qu'il comprend les étapes suivantes:

a) application dudit fil sur ladite couche isolante au-dessus dudit conducteur,

b) maintien dudit fil en contact intime avec ladite couche,

c) application d'un faisceau d'énergie focalisé dirigé vers un point qui est au moins tangentiellement en contact avec ledit fil de manière à traverser ladite couche et former un trou dans celle-ci afin d'exposer ledit conducteur au-dessous du trou, et

d) application d'une énergie supplémentaire aux parties dudit fil qui sont adjacentes audit point afin de faire fondre le métal du fil et de faire s'écouler ce métal à l'intérieur du trou pour former un contact électrique entre le fil et le conducteur.

Brève description des figures des dessins

La Figure 1 est une vue en coupe qui illustre un technique permettant de souder, au moyen d'un laser, un fil à un conducteur à films minces déposé sur un substrat et recouvert d'une mince couche de passivation.

La Figure 2 est un vue en coupe de l'ensemble de la Figure 1 que l'on obtient après avoir procédé à une nouvelle liaison du fil au conducteur au moyen d'un laser.

La Figure 3 est une vue de dessus de l'ensemble de la Figure 2.

La Figure 4 illustre une technique de liaison par laser qui permet d'effectuer une connexion avec l'extrémité d'un fil.

La Figure 5 représente l'ensemble de la Figure 4 que l'on obtient après avoir procédé à une nouvelle liaison du fil au conducteur au moyen d'un laser.

La Figure 6 set une vue analogue a celle de la Figure 2, sans couche intermédiaire de passivation.

La Figure 7 représente un dispositif permettant de mettre en oeuvre le procédé de la présente invention et faisant appel à l'emploi d'un faisceau d'ions.

La Figure 8 représente un dispositif à faisceau électronique modifié de manière à pouvoir être employé avec la présente invention.

Description de modes de réalisation

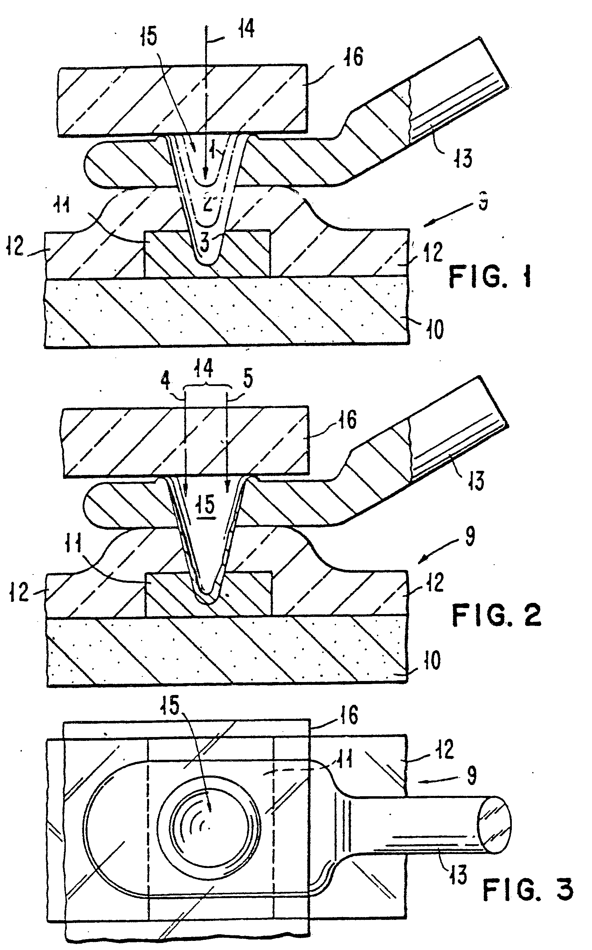

On a représenté sur la Figure 1 un fragment d'un bloc 9 comprenant un substrat 10 d'une épaisseur considérable (représenté ici sous la forme d'un substrat mince dans un but de simplicité) qui peut être constitué, par exemple, par un bloc de silicium. Un conducteur 11 constitué par un film mince d'un métal tel que de l'Al est déposé sur le silicium, comme cela se fait dans le cas d'un dispositif à couplage de charge (CCD). Le conducteur 11 peut avoir, par exemple, une largeur d'environ 5 à 10 microns et une épaisseur d'environ 0,3 à 0,5 microns. Le conducteur 11 est recouvert d'une mince couche de passivation 12 composée d'un matériau tel que du SiO ou $SiO_2$. Dans certains cas, il pourrait être souhaitable d'établir une connexion entre un fil tel que le fil 13 et le conducteur 11 qui peut avoir un diamètre d'environ 10 microns. Sur la Figure 1, le fil 13 es maintenu en position au moyen d'une plaque de verre ordinaire 16.

De telles connexions peuvent se révéler nécessaires lorsqu'on désire tester certaines parties d'un circuit, pour déterminer la présence d'éventuelles défectuosités qu'il conviendrait d'éliminer, ou pour réaliser la personnalisation du circuit d'une façon qu'il aurait été impossible de définir au préalable. Il est particulièrement important de pouvoir effectuer des soudures de faibles dimensions lorsque, par exemple, une faible inductance et une faible capacité en courant alternatif sont indispensables. Or, les sondes capables d'être utilisées dans le cas de dispositifs d'aussi faibles dimensions et présentant des géométries aléatoires possèdent des inductances et des capacités élevées, ce qui les rend inutilisables en l'occurrence.

Lorsque des lignes en aluminium qui ont fait l'objet d'une passivation sont déposées sur un substrat typique, tel qu'un substrat en silicium, deux problèmes se posent, qui jusqu'ici s'opposaient à l'obtention d'une connexion satisfaisante. En premier lieu, lorsque la couche de passivation en dioxyde de silicium et le conducteur en aluminium 11 sont chauffés, il se produit une interaction qui amène l'oxygène à se combiner avec une partie de l'aluminium, ce qui s'oppose à l'obtention d'une liaison électrique et mécanique satisfaisante et provoque la formation de couches isolantes cassantes. Deuxièmement, lorsqu'un conducteur en aluminium 11 qui n'est pas recouvert d'une couche de passivation 12 est chauffé de manière à réaliser une liaison, la surface exposée de l'aluminium s'oxyde dans une certaine mesure, ce qui, comme dans le cas précédent, s'oppose à l'obtention d'une liaison électrique et mécanique adéquate. Quoi qu'il en soit, il est évident que, pour obtenir une liaison satisfaisante entre un fil 13 en un conducteur 11, la couche de passivation 12 recouvrant le conducteur 11 doit être retirée de manière à obtenir sur ce conducteur 11 une surface permettant de réaliser une liaison électrique et mécanique satisfaisante. Le problème qui se pose en l'occurrence est de réaliser une telle connexion sans exposer le métal du conducteur 11 à une oxydation.

Comme le montre la Figure 1, une présente réalisation consiste notamment à appliquer une énergie électromagnétique fortement focalisée sous la forme d'un faisceau laser 14 pour retirer le matériau de passivation d'une façon pratiquement instantanée, de telle sorte que l'oxydation ne puisse pas se produire. Ce procédé consiste à percer un trou 15 dans le fil 13, la couche de passivation 12 et une partie de la couche 11 au moyen d'un faisceau laser 14, de telle sorte que les impulsions successives de celui-ci, référencées 1, 2 et 3 sur la Figure 1, traversent de plus en plus profondément le fil 13 (impulsion N° 1), la couche de passivation 12 (impulsion N° 2) et le conducteur 11 (impulsion N° 3). Ainsi qu'on a pu le constater, le matériau ainsi retiré est violamment éjecté du trou 15. Par ailleurs, il semblerait que le présent procédé provoque une décomposition des oxydes et favorise par conséquent la formation de soudures et de liaisons présentant une faible résistance. Le procédé connu décrit plus haut se traduit par l'obtention d'une connexion présentant une résistance électrique relativement élevée (20 000 à 30 000 ohms), et donne une connexion mécanique assez médiocre entre le fil 13 (en or, aluminium, etc. ...) et le conducteur 11 (en aluminium, etc. ...). Néanmoins, dans la liaison réalisée, une faible quantité d'oxyde est présente, semble-t-il, dans la connexion établie avec le conducteur 11.

Par ailleurs, un fait capital a été découvert lors des expériences effectuées dans le cadre de la présente invention. En effet, on a constaté que si, une fois le trou percé de la façon indiquée sur la Figure 1, le faisceau laser était ajusté (c'est-à-dire défocalisé, etc. ...) de telle sorte qu'il présente une énergie moindre dirigée davantage vers la périphérie du trou 15 et soit suffisamment chaud pour faire fondre le métal du fil 13 et le faire couler dans le trou 15, ce métal en fusion se combinait avec le métal déjà fondu qui se trouvait dans la partie inférieure du trou, ce qui permettait d'obtenir une meilleure connexion électrique et mécanique présentant une résistance inférieure à 10 ohms. Ainsi, le procédé illustré par la Figure 1 permet de connecter le fil, et la fusion ultérieure du métal qui est obtenue à une température moins élevée fait couler celui-ci à l'intérieur du trou 15 et se combiner avec le métal en fusion qui se trouve au fond du trou.

Cette combinaison des métaux en fusion est représentée d'une façon légèrement différente sur la Figure 2, qui montre la façon dont les impulsions laser ultérieures (N° 4 et N° 5) présentent une intensité moindre et dirigées vers les parties diamétralement opposées de la périphérie du trou 15, sont employées pour faire fondre le métal de la partie gauche, puis de la partie droite du trou 15 et le faire couler à l'intérieur de celui-ci, et pour faire fondre également le métal du conducteur 11 qui se trouve au-dessous. Comme le montre la Figure 2, ces impulsions N° 4 et N° 5 sont dirigées légèrement à l'intérieur des bords du trou 15. Des impulsions telles que les impulsions N° 4 et N° 5 permettent, semble-t-il, d'obtenir une plus large région de contact et une impédance nettement plus faible, mais essentiellement dans le trou pré-formé 15 qui est une région dépourvue d'oxyde.

Un faisceau laser 14 provenant d'une unique source peut être utilisé aux fins des étapes représentées sur les Figures 1, 2 et 3, si, dans le case du dernier groupe d'impulsions, le laser est défocalisé ou si l'on diminue son intensité de manière à réduire la quantité d'énergie par unité de surface parvenant à l'intérieur du trou 15 pour éviter de percer davantage le métal 11 ou 13. Un laser à impulsions courtes, d'une durée de $5 \times 10^{-9}$ secondes, tel qu'un laser constitué par un colorant pompé à l'azote, a été utilisé avec succès. Le laser employé doit pouvoir être focalisé jusqu'à un diamètre de quelques microns. On peut également se servir d'autres lasers, par exemple d'un laser YAG (yttrium-aluminium-grenat), d'un laser YAG à double fréquence ou d'un laser à rubis déclenché (qui fournissent des impulsions de courte durée et de forte intensité). Des lasers au xénon à impulsions plus longues sont également satisfaisants avec une puissance par unité de surface ou un flus proportionnellement plus faible.

Le fils 13 doit être maintenu en place ou pressé par des moyens tels que la plaque de verre 16 afin de l'empêcher de s'écarter de la position qu'il occupe au-dessus du bloc 9. On peut en pratique fournir un support au fil à l'aide d'un outil qui fixerait les extrémités du fil. On pourrait également appliquer le fil sur un bloc au moyen d'un outil approprié et retirer ce dernier avant l'opération de perçage de manière à obtenir une adhérence suffisante en utilisant l'étape de pressage. Le fil 13 ne bouge généralement pas lorsqu'on utilise cette dernière technique. L'emploi d'éléments de fixation en verre pendant les opérations de perçage et de liaison permet d'obtenir de meilleurs résultats.

On a constaté que, lorsque l'extrémité du fil 13 est aplatie, comme le montre notamment la Figure 1, on obtient une meilleure liaison et l'emploi d'une plaque de verre pour presser et son enlèvement ultérieur avant le perçage au moyen d'un laser se révèle plus efficace. Si le laser traverse complètement le métal 11, on peut néanmoins obtenir une liaison excellente. S'il est nécessaire d'éviter de percer plus bas que le métal 11, on peut employer une "fenêtre" de perçage étroite aux fins de n'importe quelle application donnée. La durée des impulsions, la puissance par unité de surface, etc., peuvent être ajustées à l'intérieur de cette fenêtre, et l'on pourra éviter, en procédant par tâtonnements, tout perçage excessif.

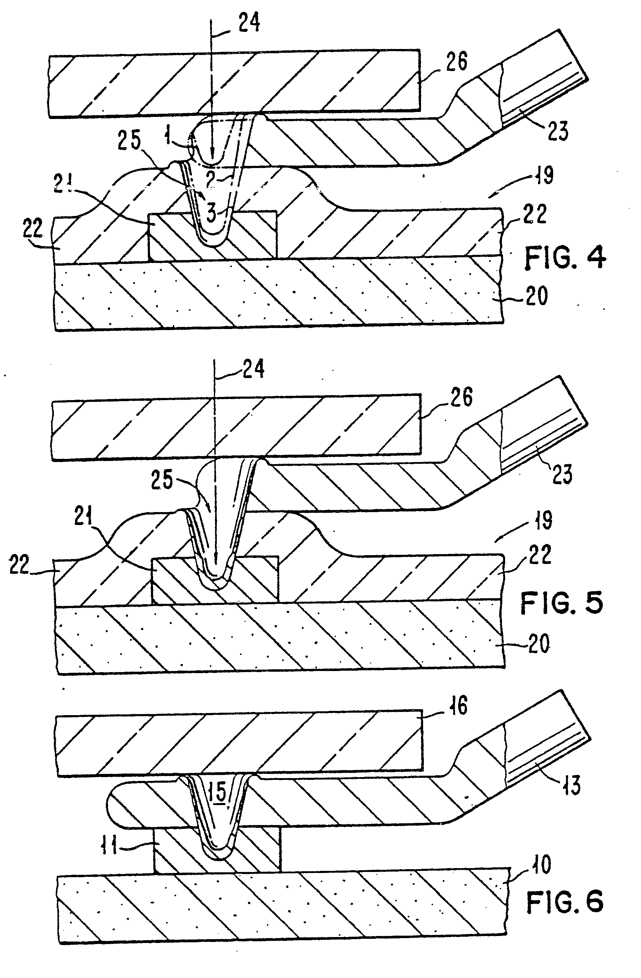

La Figure 4 représente la connexion, réalisée au moyen d'un laser, d'un bloc 19 à l'extrémité d'un fil 23, dans le cas où le substrat 20, le conducteur 21, la couche de passivation 22, le fil 23 et la plaque 26 sont identiques. Trois impulsions, par exemple, du faisceau laser 24 permettent de percer le trou 25.

La Figure 5 montre le résultat obtenu lorsqu'on expose le bloc de la Figure 4 aux nouvelles impulsions d'un faisceau laser défocalisé de façon à mélanger les métaux en fusion, ce qui si traduit par l'obtention d'une résistance électrique moins importante et d'une meilleure liaison mécanique.

La Figure 6 montre que un procédé de la présente invention peut être employé pour lier à un fil un conducteur disposé sur un bloc ne comportant aucune couche de passivation.

La Figure 7 représente un dispositif à faisceau d'ions qui permet de mettre en oeuvre la présente invention. Une source d'ions 70 engendre un faisceau impulsionnel d'ions qui est dirigé par l'ouverture 71 dans la chambre 72 contenant un ensemble 73 qui comprend un substrat 74, un conducteur à films minces 75 et une couche de passivation 76. Un fil 77 est appliqué sur l'ensemble 73 sans organe de fixation externe et est soutenu par un élément indiqué par la ligne pointillée 78. Une lentille d'Einzel est formée par des éléments cylindriques 79, 80 et 81 qui focalisent le faisceau d'ions. Les éléments 79 et 81 sont à la masse et l'élément 80 reçoit la tension de focalisation $V_F$ que l'on fait varier aux fins des opérations de perçage de trou et de "soudure" (ou de liaison). Une électrode 82 qui reçoit un tension de cible permet d'ajuster l'énergie du faisceau lorsque celui-ci frappe l'ensemble 73, selon qu'il s'agit de percer des trous (tensions élevées) et de faire fondre le métal ou d'obtenir une liaison ou une "soudure" (tensions plus faibles). La source d'ions 70 comprend un circuit de commande d'extracteur qui permet de déclencher et d'interrompre le faisceau. Des moyens de commande d'impulsions 83 sont connectés à ce dernier circuit et permettent de déclencher et d'interrompre le faisceau d'ions à la cadence désirée.

Un support x-y 84 est prévu afin de déplacer l'ensemble 73 au-dessous du faisceau jusqu'à ce qu'il soit correctement aligné, ceci étant indiqué au moyen d'un dispositif vidéo standard (non représenté).

Les opérations de perçage de trous et de liaison (ou de soudure) peuvent également être effectuées au moyen d'un dispositif de perçage à faisceau électronique du type décrit dans les brevets des E.U.A. N° 3 793 281, lequel décrit le perçage de trous au moyen d'électrons, E.U.A. N° 3 644 700, qui décrit des moyens permettant d'obtenir une déflexion de faisceaux électroniques, et E.U.A. N° 2 902 583.

Le dispositif est schématiquement représenté sur la Figure 8 et comprend une chambre 85 comportant une source de faisceau d'électrons focalisé 86 qui peut être commandé de la façon classique décrite dans le brevet précité N° 2 902 583. Ce faisceau peut également être défocalisé de manière à effectuer une liaison ou une soudure à une plus faible intensité par unité de surface du faisceau autour de la périphérie du trou. L'ensemble 73 est identique à celui de la Figure 7, à l'exception du fait que la plaque 16 de la Figure 1 a été remplacée par des doigts de fixation 88.

A titre d'exemple, des trous de 5 microns peuvent être percés dans un fil d'aluminium de 12 microns au moyen d'un laser dont le faisceau présente une densité de puissance incidente d'environ $5 \times 10^9$ watts/cm². La fusion du métal à la périphérie du trou est ultérieurement obtenue en ramenant cette valeur à environ $2 \times 10^9$ watts/cm².

Il est également possible d'utiliser, pour la réalisation de la présente invention, comme faisceau d'énergie, un faisceau de rayons X.

Le procédé de la présente invention permet de fabriquer de petits dispositifs tels que des petits blocs de circuit, des cartes de circuit, des modules ou des dispositifs à jonction de Josephson.

Bien que l'on ait décrit dans ce qui précède et représenté sur les dessins les caractéristiques essentielles de l'invention appliquées à un mode de réalisation préféré de celle-ci, il est évident que l'homme de l'art peut y apporter toutes modifications de forme ou de détail qu'il juge utiles, sans pour autant sortir du cadre de ladite invention selon les revendications.

**Revendications**

1. Procédé pour lier un fil métallique (13) à un conducteur de microcircuit (11), caractérisé en ce qu'il comprend les étapes suivantes:

a) application dudit fil sur le conducteur,

b) maintien dudit fil en contact intime avec ledit conducteur,

c) application d'un faisceau d'énergie (14) focalisé dirigé vers un point qui est au moins tangentiellement en contact avec ledit fil, et formation d'un trou dans ledit conducteur, et

d) application d'une énergie supplémentaire aux parties dudit fil qui sont adjacentes audit point afin de faire fondre le métal du fil et de faire s'écouler ce métal à l'intérieur du trou (15) pour former un contact électrique entre le fil et le conducteur.

2. Procédé pour lier un fil métallique (13) à un conducteur de micro-circuit (11) disposé au-dessous d'une couche isolante (12), caractérisé en ce qu'il comprend les étapes suivantes:

a) application dudit fil sur ladite couche isolante au-dessus dudit conducteur,

b) maintien dudit fil en contact intime avec ladite couche,

c) application d'un faisceau d'énergie (14) focalisé dirigé vers un point qui est au moins tangentiellement en contact avec ledit fil de manière à traverser ladite couche et former un trou (15) dans celle-ci afin d'exposer ledit conducteur au-dessous du trou, et

d) application d'une énergie supplémentaire aux parties dudit fil qui sont adjacentes audit point afin de faire fondre le métal du fil et de faire s'écouler ce métal à l'intérieur du trou pour former un contact électrique entre le fil et le conducteur.

3. Procédé selon la revendication 1 ou 2 caractérisé en ce que le fil est appliqué sur le conducteur ou sur la couche isolante dans la position désirée au moyen d'un instrument, et en ce qu'une plaque de verre (16) est disposée au-dessus de lui de manière à le maintenir en place lors des étapes suivantes du procédé.

4. Procédé selon l'une quelconque des revendications 1 à 3, caractérisé en ce que la partie dudit fil qui est appliquée sur ledit conducteur métallique ou ladite couche isolante est aplatie avant sa mise en place.

5. Procédé selon la revendication 4 caractérisé en ce que la partie dudit fil qui est appliquée sur ledit conducteur métallique ou ladite couche isolante est l'extrémité du fil.

6. Procédé selon l'une quelconque des revendications 1 à 5 caractérisé en ce que l'on applique le faisceau d'énergie de telle sorte que celui-ci traverse la partie dudit fil appliquée sur ledit conducteur métallique ou ladite couche isolante, jusque dans le conducteur métallique, le diamètre dudit faisceau étant plus faible que celui du fil, de sorte que le matériau est retiré du fil en laissant des trous alignés entre celui-ci et le conducteur métallique.

7. Procédé selon l'une quelconque des revendications 1 à 6 caractérisé en ce que l'application d'une énergie supplémentaire est réalisée par la modification du faisceau d'énergie de façon à en augmenter légèrement le diamètre tout en restant inférieur à celui du fil, et une ou plusieurs applications successives du faisceau de manière à établir une connexion électrique présentant une faible résistance entre le fil et le conducteur métallique par fusion du métal à la périphérie du trou.

8. Procédé selon l'une quelconque des revendications 1 à 6, caractérisé en ce que l'application d'une énergie supplémentaire est réalisée par une nouvelle application d'un faisceau d'énergie pour faire fondre le métal dudit fil à la périphérie du trou, cette dernière application étant effectuée en une ou plusieurs fois, de manière à établir une connexion électrique présentant une faible résistance entre ledit fil et ledit conducteur métallique.

9. Procédé selon l'une quelconque des revendications 1 à 8, caractérisé en ce que ledit faisceau d'énergie se compose d'un faisceau laser ou d'un faisceau d'ions ou d'un faisceau d'électrons ou d'un faisceau de rayons X.

**Patentansprüche**

1. Verfahren zum Verbinden eines metallischen Drahtes (13) mit einem Mikroschaltungsleiter (11), dadurch gekennzeichnet, daß es die folgenden Verfahrensschritte einschließt:

a. Auflegen dieses Drahtes auf den Leiter,

b. Halten dieses Drahtes in engem Kontakt mit diesem Leiter,

c. Anwenden eines fokussierten Energiestrahls (14), der auf einen wenigstens in Tangentialberührung mit dem Draht stehenden Punkt gerichtet wird, und Bilden eines Lochs in dem Leiter, und

d. Anwenden weiterer Energie an den Teilen des Drahtes, die an diesen Punkt angrenzen, so daß das Metall des Drahtes zum Schmelzen gebracht wird und dieses Metall in das Innere des Loches (15) fließt, um einen elektrischen Kontakt zwischen dem Draht und dem Leiter zu bilden.

2. Verfahren zum Verbinden eines Metalldrahtes (13) mit einem Mikroschaltleiter (11), der über einer Isolierschicht (12) angeordnet ist, dadurch gekennzeichnet, daß es folgende Verfahrensschritte einschließt:

a. Auflegen des Drahtes auf die Isolierschicht über dem Leiter,

b. Halten des Drahtes in engem Kontakt mit dieser Schicht,

c. Anwenden eines fokussierten Energiestrahls (14), der auf den Punkt gerichtet wird, der wenigstens in Tangentialberührung mit diesem Draht steht, so daß er diese Schicht durchdringt und in ihr ein Loch (15) bildet, damit der Leiter unter dem Loch freigelegt wird, und

d. Anwenden weiterer Energie an den Teilen des Drahtes, die an diesen Punkt angrenzen, damit das Metall des Drahtes zum Schmelzen kommt und dieses Metall in das Innere des Loches fließt, um einen elektrischen Kontakt zwischen dem Draht und dem Leiter zu bilden.

3. Verfahren nach Anspruch 1 oder 2, dadurch gekennzeichnet, daß der Draht mit Hilfe eines Instrumentes in der gewünschten Lage auf den Leiter oder die Isolierschicht gelegt wird, und daß eine Glasplatte (16) über ihm angebracht ist, um ihn während der folgenden Verfahrensschritte in Position zu halten.

4. Verfahren nach einem der Ansprüche 1 bis 3, dadurch gekennzeichnet, daß man den Teil des Drahtes, der auf den metallischen Leiter oder die Isolierschicht aufgelegt wird, vor seinem Anbringen abflacht.

5. Verfahren nach Anspruch 4, dadurch gekennzeichnet, daß der Teil des Drahtes, der auf den metallischen Leiter oder die Isolierschicht aufgelegt wird, das Drahtende ist.

6. Verfahren nach einem der Ansprüche 1 bis 5, dadurch gekennzeichnet, daß der Energiestrahl so angewendet wird, daß er den Drahtteil, der auf den metallischen Leiter oder die Isolierschicht aufgelegt ist, bis zu dem metallischen Leiter durchdringt, wobei der Durchmesser des Strahls kleiner ist als der des Drahtes, so daß Material vom Draht entfernt wird und dabei zwischen diesem und dem metallischen Leiter ausgerichtete Löcher zurückbleiben.

7. Verfahren nach einem der Ansprüche 1 bis 6, dadurch gekennzeichnet, daß man die weitere Energie anwendet, indem man den Energiestrahl so verändert, daß sich sein Durchmesser leicht vergößert, derselbe aber dennoch kleiner bleibt als der des Drahtes, und indem man den Strahl einmal oder mehrmals anwendet, um durch das Schmelzen des Metalls auf der Lochperipherie einen niederohmigen elektrischen Kontakt zwischen dem Draht und dem metallischen Leiter herzustellen.

8. Verfahren nach einem der Ansprüche 1 bis 6, dadurch gekennzeichnet, daß das Anwenden einer weiteren Energie durch ein erneutes Anwenden eines Energiestrahles erfolgt, um das Metall des Drahtes auf der Lochperipherie zum Schmelzen zu bringen, wobei dieses letztere Anwenden einmal oder mehrmals geschieht, um einen niederohmigen elektrischen Kontakt zwischen dem Draht und dem metallischen Leiter herzustellen.

9. Verfahren nach einem der Ansprüche 1 bis 8, dadurch gekennzeichnet, daß der Energiestrahl aus einem Laserstrahl oder einem Ionenstrahl oder einem Elektronenstrahl oder einem Röntgenstrahlenbündel besteht.

## Claims

1. A method for bonding a metallic wire (13) to a microcircuit conductor (11), characterized in that it includes the steps of:

a. applying said wire to the conductor,

b. maintaining said wire in close contact with said conductor,

c. applying a focussed energy beam (14) directed towards a point at least tangentially in contact with said wire, and forming a hole in said conductor, and

d. applying additional energy to portions of said wire adjacent to said point for melting the wire metal so that the metal flows into said hole (15) to form an electrical contact between the wire and the conductor.

2. A method for bonding a metal wire (13) to a microcircuit conductor (11) arranged beneath an insulating layer (12), characterized in that it includes the steps of:

a. applying said wire to said insulating layer over said conductor,

b. maintaining said wire in close contact with said layer,

c. applying a focussed energy beam (14) directed towards a point at least tangentially in contact with said wire so as to pass through said layer, thus forming a hole (15) in the latter to expose said conductor beneath the hole, and

d. applying additional energy to the portions of said wire adjacent to said point for melting the wire metal so that said metal flows into the hole to form an electrical contact between the wire and the conductor.

3. A method according to claim 1 or 2, characterized in that the wire is applied to the conductor or to the insulating layer in the desired position by means of a device, and a glass plate (16) is arranged over it so as to maintain it in place during the subsequent steps of the method.

4. A method according to any one of claims 1 to 3, characterized in that the wire portion that is applied to said metal conductor or said insulating layer is flattened before it is positioned.

5. A method according to claim 4, characterized in that the portion of said wire applied to said metal conductor or said insulating layer is the end of the wire.

6. A method according to any one of claims 1 to 5, characterized in that the energy beam is directed in such a way that it passes through the portion of said wire applied to said metal conductor or said insulating layer down to the metal conductor, the diameter of said beam being smaller than that of the wire. so that material is removed from the latter, leaving holes aligned between the wire and the metal conductor.

7. A method according to any one of claims 1 to 6, characterized in that the application of additional energy is achieved by modifying the energy beam so as to slightly increase its diameter which is, however still smaller than that of the wire, and by applying the beam once, or several times successively so as to establish an electrical connection with a low resistance between the wire and the metal conductor due to the melting of the metal of the hole periphery.

8. A method according to any one of claims 1 to 6, characterized in that the application of an additional energy is achieved by a new application of an energy beam to melt the metal of said wire at the hole periphery, the latter application being performed once or several times so as to establish an electrical connection with a low resistance between said wire and said metal conductor.

9. A method according to any one of claims 1 to 8, characterized in that said energy beam consists of a laser beam, or an ion beam, or an electron beam, or an X ray beam.

FIG. 1

FIG. 2

FIG. 3

FIG. 4

FIG. 5

FIG. 6

0010610

FIG. 7

POMPE
A VIDE

FIG. 8